# EUROPEAN PATENT SPECIFICATION

(11) **EP 2 811 531 B1**
(45) Date of publication and mention of the grant of the patent: **04.09.2019**
(21) Application number: 13170434.8
(22) Date of filing: 04.06.2013
(51) Int. Cl.: H01L 29/788, G11C 16/04, H01L 27/115

(54) **EPROM single-poly memory**
Single-Poly-EPROM-Speicher
Mémoire EPROM du type single-poly

(43) Date of publication of application: 10.12.2014
(73) Proprietor: eMemory Technology Inc., Hsin-Chu 30075 (TW)
(72) Inventor: Chen, Wei-Ren, 900 Pingtung County (TW); Hsu, Te-Hsun, 310 Hsinchu County (TW); Lee, Wen-Hao, 302 Hsinchu County (TW)
(74) Representative: Krauns, Christian

(56) References cited:
- US-A1- 2008 169 500
- US-A1- 2010 149 874
- US-A1- 2012 056 257
- US-B1- 8 076 707

## Description

### FIELD OF THE INVENTION

The present invention relates to a nonvolatile memory, and more particularly to an erasable programmable single-poly nonvolatile memory.

### BACKGROUND OF THE INVENTION

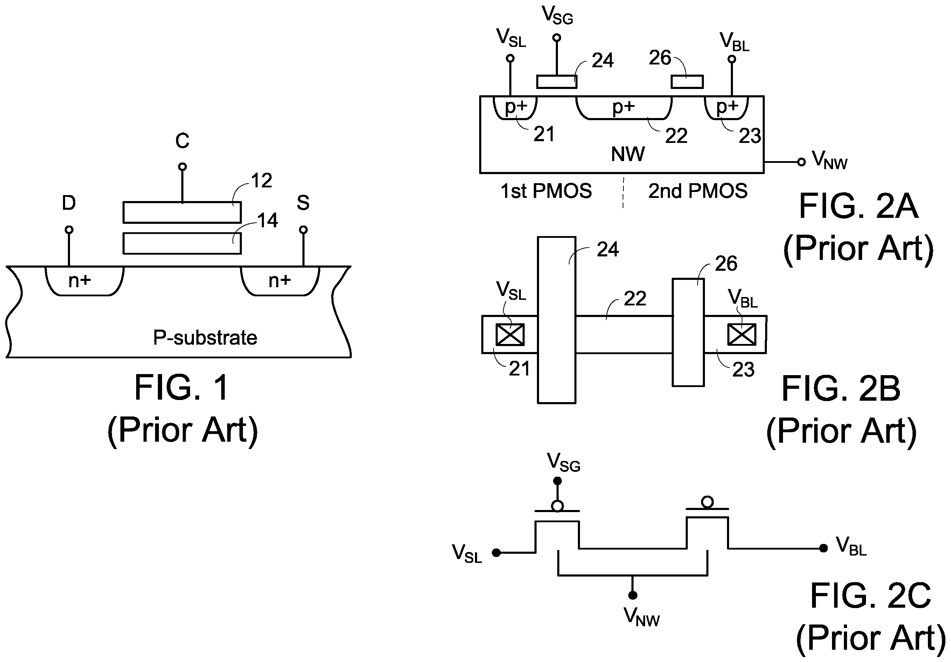

FIG. 1 is a schematic cross-sectional view illustrating a conventional programmable dual-poly nonvolatile memory. The programmable dual-poly nonvolatile memory is also referred as a floating-gate transistor. As shown in FIG. 1, this nonvolatile memory comprises two stacked and separated gates. The upper gate is a control gate 12, which is connected to a control line C. The lower gate is a floating gate 14. In addition, an n-type doped source region and an n-type doped drain region are constructed in a P-substrate. The n-type doped source region is connected to a source line S. The n-type doped drain region is connected to a drain line D.

In a case that the nonvolatile memory is in a programmed state, a high voltage (e.g. +16V) is provided by the drain line D, a ground voltage is provided by the source line S, and a control voltage (e.g. +25V) is provided by the control line C. Consequently, during the electrons are transmitted from the source line S to the drain line D through an n-channel region, the hot carriers (e.g. hot electrons) are attracted by the control voltage on the control gate 12 and injected into the floating gate 14. Under this circumstance, a great number of carriers are accumulated in the floating gate 14. Consequently, the programmed state may be considered as a first storage state (e.g. "0").

In a case that the nonvolatile memory is in a non-programmed state, no carrier is injected into the floating gate 14, and thus the non-programmed state may be considered as a second storage state (e.g. "1").

In other words, the characteristic curves of the drain current (id) and the gate-source voltage (Vgs) (i.e. an id-Vgs characteristic curve) in the first storage state and the id-Vgs characteristic curve in the second storage state are distinguished. Consequently, the storage state of the floating-gate transistor may be realized according to the variation of the id-Vgs characteristic curve.

However, since the floating gate 14 and the control gate 12 of the programmable dual-poly nonvolatile memory should be separately produced, the process of fabricating the programmable dual-poly nonvolatile memory needs more steps and is incompatible with the standard CMOS manufacturing process.

US patent No. 6678190 discloses a programmable single-poly nonvolatile memory. FIG. 2A is a schematic cross-sectional view illustrating a conventional programmable single-poly nonvolatile memory disclosed in US patent No. 6678190. FIG. 2B is a schematic top view illustrating the conventional programmable single-poly nonvolatile memory of FIG. 2A. FIG. 2C is a schematic circuit diagram illustrating the conventional programmable single-poly nonvolatile memory of FIG. 2A.

Please refer to FIGS. 2A∼2C. The conventional programmable single-poly nonvolatile memory comprises two serially-connected p-type metal-oxide semiconductor (PMOS) transistors. The first PMOS transistor is used as a select transistor, and a select gate 24 of the first PMOS transistor is connected to a select gate voltage V_{SG}. A first source/drain region 21 is connected to a source line voltage V_{SL}. Moreover, a second source/drain region 22 may be considered as a combination of a p-type drain region of the first PMOS transistor and a first p-type source region of the second PMOS transistor. A floating gate 26 is disposed over the second PMOS transistor. A third source/drain region 23 of the second PMOS transistor is connected to a bit line voltage V_{BL}. Moreover, these PMOS transistors are constructed in an N-well region (NW). The N-well region is connected to an N-well voltage V_{NW}. The second PMOS transistor is used as a floating gate transistor.

By properly controlling the select gate voltage V_{SG}, the source line voltage V_{SL}, the bit line voltage V_{BL} and the N-well voltage V_{NW}, the conventional programmable single-poly nonvolatile memory may be operated in a programmed state or a read state.

Since the two PMOS transistors of the conventional programmable single-poly nonvolatile memory have respective gates 24 and 26, the process of fabricating the conventional programmable single-poly nonvolatile memory is compatible with the standard CMOS manufacturing process.

As described in FIGS. 1 and 2, the nonvolatile memory is programmable. The electrical property of the nonvolatile memory is only utilized to inject a great number of hot carriers to the floating gate. However, the electrical property fails to be utilized to remove the carriers from the floating gate. That is, for achieving the data-erasing function, the carriers stored in the floating gate may be removed from the floating gate by exposing ultraviolet (UV) light to the nonvolatile memory. These nonvolatile memories are named as one time programming (OTP) memories.

The patent US 8 076 707 B1 discloses a nonvolatile memory comprising a floating gate disposed on an insulating layer, a first segment of the floating gate located proximately to the contacts of the first conductivity type relative to the contacts of the second conductivity type, and a second segment of the floating gate located proximately to the contacts of the second conductivity type relative to the contacts of the first conductivity type, wherein the first insulating layer placed underneath the floating gate is of a thickness to cause direct tunneling of charge between the substrate and the floating gate responsive to applying a voltage difference between the substrate and the floating gate.

The published patent application US 2010/0149874 A1 discloses an erasable nonvolatile memory cell with a deep N-well located in the P substrate, while a P-well and an N-well are located in the deep N-well. The memory cell includes a PMOS transistor located in the N-well, in which the PMOS transistor includes a PMOS gate-oxide, and an NMOS capacitor located in the P-well. The NMOS capacitor includes an N+ coupling region located in the P-well, and an NMOS gate-oxide. The memory cell includes a floating gate comprised of a poly-silicon gate overlying the PMOS transistor and the NMOS capacitor.

Therefore, for multi-times programming (MTP) memories design, there is a need of providing an erasable programmable single-poly nonvolatile memory.

### SUMMARY OF THE INVENTION

The problem of the present invention is solved for an erasable programmable single-poly nonvolatile memory according to the preamble of claim 1 by the combination of features according to the characterizing part of claim 1.

Numerous objects, features and advantages of the present invention will be readily apparent upon a reading of the following detailed description of embodiments of the present invention when taken in conjunction with the accompanying drawings. However, the drawings employed herein are for the purpose of descriptions and should not be regarded as limiting.

### BRIEF DESCRIPTION OF THE DRAWINGS

The above objects and advantages of the present invention will become more readily apparent to those ordinarily skilled in the art after reviewing the following detailed description and accompanying drawings, in which:
FIG. 1 (prior art) is a schematic cross-sectional view illustrating a conventional programmable dual-poly nonvolatile memory;
FIG. 2A (prior art) is a schematic cross-sectional view illustrating a conventional programmable single-poly nonvolatile memory disclosed in US patent No. 6678190;
FIG. 2B (prior art) is a schematic top view illustrating the conventional programmable single-poly nonvolatile memory of FIG. 2A;
FIG. 2C (prior art) is a schematic circuit diagram illustrating the conventional programmable single-poly nonvolatile memory of FIG. 2A;
FIGS. 3A∼3D schematically illustrate an erasable programmable single-poly nonvolatile memory according to an example useful for the understanding of the present invention;
FIGS. 4∼5 schematically illustrate different substrate structures and P-well region (PW) applied according to an embodiment of the present invention;
FIGS. 6A∼6B schematically illustrate another erase gate region capable of replacing the erase gate region shown in the example;
FIGS. 7∼8 schematically illustrate different substrate structures and P-well region (PW) according to an embodiment of the present invention; and
FIG. 9 shows two voltage biasing methods in erased state.

### DETAILED DESCRIPTION OF PREFERRED EMBODIMENTS

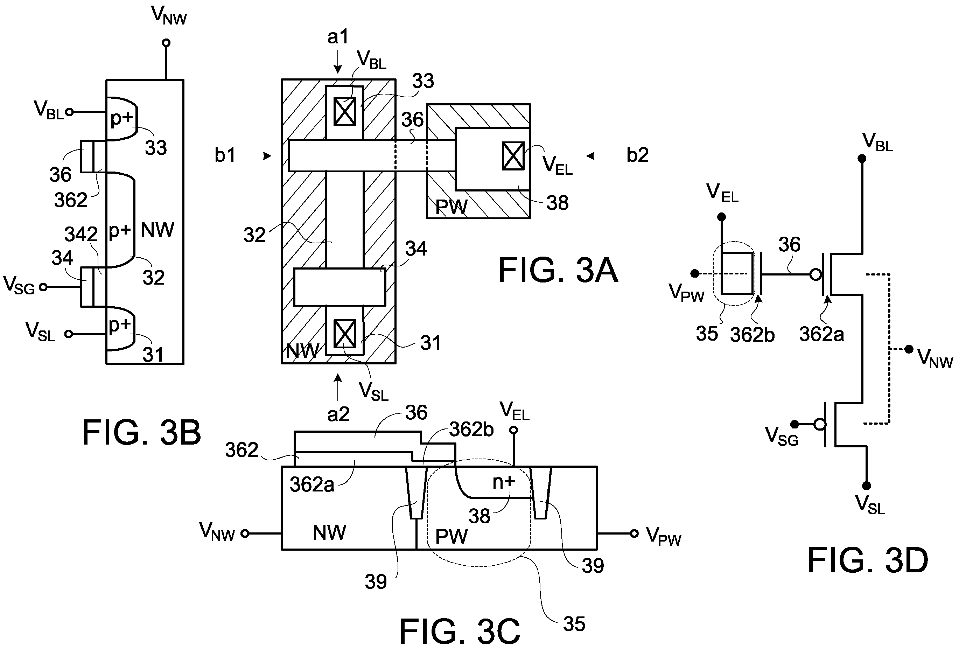

FIGS. 3A∼3D schematically illustrate an erasable programmable single-poly nonvolatile memory according to an example useful for the understanding of the present invention. FIG. 3A is a schematic top view illustrating the erasable programmable single-poly nonvolatile memory according to the example useful for the understanding of the present invention. FIG. 3B is a schematic cross-sectional view illustrating the erasable programmable single-poly nonvolatile memory of FIG. 3A and taken along a first direction (a1-a2). FIG. 3C is a schematic cross-sectional view illustrating the erasable programmable single-poly nonvolatile memory of FIG. 3A and taken along a second direction (b1-b2). FIG. 3D is a schematic equivalent circuit diagram of the erasable programmable single-poly nonvolatile memory according to the example useful for the understanding of the present invention. Furthermore, the nonvolatile memory of the present invention is manufactured by using a single poly process, which is compatible with a logical CMOS fabrication process.

As shown in FIGS. 3A and 3B, the erasable programmable single-poly nonvolatile memory of the example comprises two serially-connected p-type metal-oxide semiconductor (PMOS) transistors. These two PMOS transistors are constructed in an N-well region (NW). Three p-type source/drain regions 31, 32 and 33 are formed in the N-well region (NW). In addition, two polysilicon gates 34 and 36 are spanned over the areas between the three p-type source/drain regions 31, 32 and 33, and gate oxides layer 342 and 362 are formed between the two polysilicon gates 34 and 36 and a top surface of the semiconductor. Moreover, two polysilicon gates 34 and 36 above the N-well region (NW) are P-doped polysilicon gates 34 and 36.

The first PMOS transistor is used as a select transistor, and the polysilicon gate 34 (also referred as a select gate) of the first PMOS transistor is connected to a select gate voltage V_{SG}. The first source/drain region 31 is a p-type source region and connected to a source line voltage V_{SL}. The second source/drain region 32 is a p-type drain region. Also, the p-type source/drain region 32 may be considered as a combination of the p-type drain region of the first PMOS transistor and a p-type source region of the second PMOS transistor. The polysilicon gate 36 (also referred as a floating gate) is disposed over the second PMOS transistor. The third source/drain region 33 is a p-type drain region of the second PMOS transistor and connected to a bit line voltage V_{BL}. Moreover, the second PMOS transistor includes a channel region formed in the N-well region and the N-well region (NW) is connected to an N-well voltage V_{NW}. The second PMOS transistor is used as a floating gate transistor.

As shown in FIGS. 3A and 3C, the erasable programmable single-poly nonvolatile memory of the example comprises an n-type metal-oxide semiconductor (NMOS) transistor or a combination of the floating gate 36, gate oxide layer 362 and an erase gate region 35. The NMOS transistor is constructed in a P-well region (PW). An n-type source/drain region 38 is formed in the P-well region (PW). In other words, the erase gate region 35 includes the P-well region (PW) and the n-type source/drain regions 38. Furthermore, the floating gate 36 above the P-well region (PW) is an N-doped polysilicon gate. Also, the P-well region (PW) can be a P-doped well region and the N-well region can be an N-doped well region.

As shown in FIG. 3A, the floating gate 36 is extended to and is adjacent to the erase gate region 35. Moreover, the n-type source/drain region 38 may be considered as a combination of an n-type source region and an n-type drain region of the NMOS transistor and the floating gate 36 may be considered as a gate of the NMOS transistor. The n-type source/drain region 38 is connected to an erase line voltage V_{EL}. In addition, the P-well region (PW) is connected to a P-well voltage V_{PW}. As shown in FIG. 3C, the gate oxide layer 362 is formed under the floating gate 36, and the gate oxide layer 362 includes two portions 362a and 362b. The first portion 362a of the gate oxide layer 362 is formed in the floating gate transistor (second PMOS transistor) and the second portion 362b of the gate oxide layer 362 is formed in the NMOS transistor (or above the erase gate region 35). According to the example useful for the understanding of the present invention, an etching back process is adopted to etch the second portion of the gate oxide layer. In this way, a thickness of the first portion 362a of the gate oxide layer 362 is thicker than a thickness of the second portion 362b of the gate oxide layer 362. Furthermore, an isolation structure 39 is formed between the P-well region (PW) and the
N-well region (NW). For example, the isolation structure 39 is a shallow trench isolation (STI) structure.

As shown in FIG. 3D, the erase gate region 35 also can be seen as a tunneling capacitor for the storage carriers eject from the floating gate 36 to out of the nonvolatile memory through the tunneling capacitor.

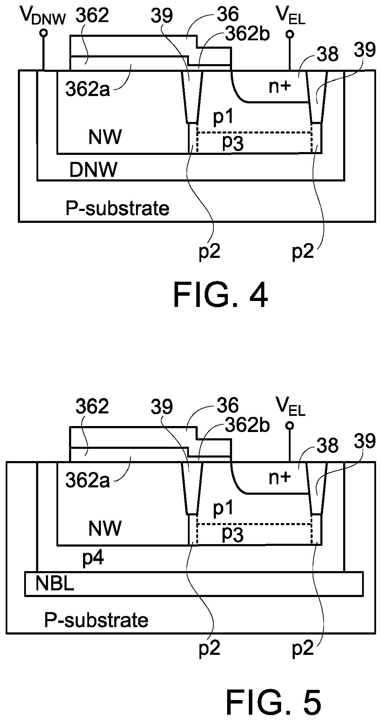

Furthermore, different substrate structures and P-well region (PW) according to an embodiment of the present invention will be illustrated in more details as follows. As shown in FIG. 4, the substrate structure includes a deep N-well region (DNW) and a P-substrate. The deep N-well region (DNW) is formed in the P-substrate and the deep N-well region (DNW) is connected to a deep N-well voltage V_{DNW}.

The N-well region (NW) and the P-well region (PW) of the embodiment are formed in the deep N-well region (DNW) of the substrate structure. The P-well region (PW) further comprises a first p-type region (p1), two second p-type regions (p2), and a third p-type region (p3). The dosage in the second p-type region (p2) is higher than the dosage in the first p-type region (p1). Also, the dosage in the third p-type region (p3) is higher than the dosage in the first p-type region (p1).

In addition, the first p-type region (p1) is formed under the surface of the substrate structure and contacted to the n-type source/drain region 38; and the third p-type region (p3) is formed under the first p-type region (p1). Furthermore, the first p-type region (p1) and the third p-type region (p3) are located between the two second p-type regions (p2), which are formed under the two isolation structures 39.

According to FIG. 4 of the present invention, the junction breakdown voltage between the n-type source/drain region 38 and the first p-type region (p1) is increased and thus the erase efficiency of the erasable programmable single-poly nonvolatile memory is improved. Furthermore, the two second p-type regions (p2) are capable of improving the lateral punch through effect between the n-type source/drain region 38 and the N-well region (NW); and the third p-type region (p3) is capable of improving the vertical punch through effect between the n-type source/drain region 38 and the deep N-well region (DNW), especially in the high temperature environment.

As shown in FIG. 5, the substrate structure includes a fourth p-type region (p4), an n-type barrier layer (NBL, i.e a second n-type region), and a P-substrate. The n-type barrier layer (NBL) is formed in the P-substrate, and the fourth p-type region (p4) is formed above and contacted to the n-type barrier layer (NBL).

The N-well region (NW) and the P-well region (PW) of the first embodiment are formed in the fourth p-type region (p4) of the substrate structure. The P-well region (PW) further comprises a first p-type region (p1), two second p-type regions (p2), and a third p-type region (p3). The dosage in the second p-type region (p2) is higher than the dosage in the first p-type region (p1). Also, the dosage in the third p-type region (p3) is higher than the dosage in the first p-type region (p1). In addition, the dosage in the fourth p-type region (p4) is equal to the dosage in the P-substrate. Or, the dosage in the fourth p-type region (p4) is higher than or equal to the dosage in the third p-type region (p3) and the dosage in the fourth p-type region (p4) is lower than or equal to the dosage in the second p-type region (p2).

In addition, the first p-type region (p1) is formed under the surface of the substrate structure and contacted to the n-type source/drain region 38; and the third p-type region (p3) is formed under the first p-type region (p1). Furthermore, the first p-type region (p1) and the third p-type region (p3) are located between the two second p-type regions (p2), which are formed under the two isolation structures 39.

According to FIG. 5 of the present invention, the junction breakdown voltage between the n-type source/drain region 38 and the first p-type region (p1) is increased and thus the erase efficiency of the erasable programmable single-poly nonvolatile memory is improved. Furthermore, the two second p-type regions (p2) are capable of improving the lateral punch through effect between the n-type source/drain region 38 and the N-well region (NW) at higher temperature; and the third p-type region (p3) is capable of improving the vertical punch through effect between the n-type source/drain region 38 and the n-type barrier layer (NBL) at higher temperature. Also, the N-well region (NW) of the embodiment is isolated by the fourth p-type region (p4) and the P-well region (PW), thus the independent bias voltage is capable of reducing the voltage stress between the floating gate 36 and the N-well region (NW).

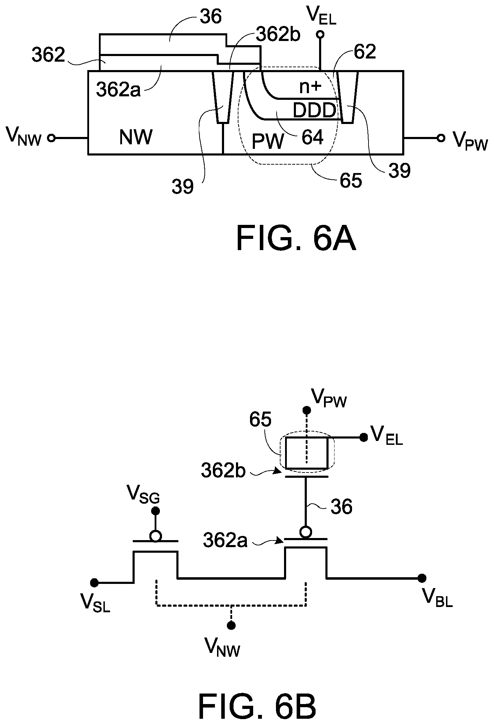

FIGS. 6A∼6B schematically illustrate another erase gate region capable of replacing the erase gate region 35 shown in the example useful for understanding the present invention. The structure of the first PMOS transistor (select transistor) and the second PMOS transistor (floating gate transistor) are the same with FIG. 3B, and are not redundantly shown herein.

As shown in FIG. 6A and 6B, there is a double diffused drain (DDD) region 64 (i.e. a first n-type region (n1)) formed between the n-type source/drain regions 62 and the P-well region (PW) in the erase gate region 65 comparing with FIG. 3C. To achieving a lower erase line voltage (V_{EL}), a thickness of the second portion 362b of the gate oxide layer 362 is thinner than a thickness of the first portion 362a of the gate oxide 362.

FIG. 6B shows the equivalent circuit diagram of the erasable programmable single-poly nonvolatile memory including the first PMOS transistor, the second PMOS transistor, and the erase gate region 65.

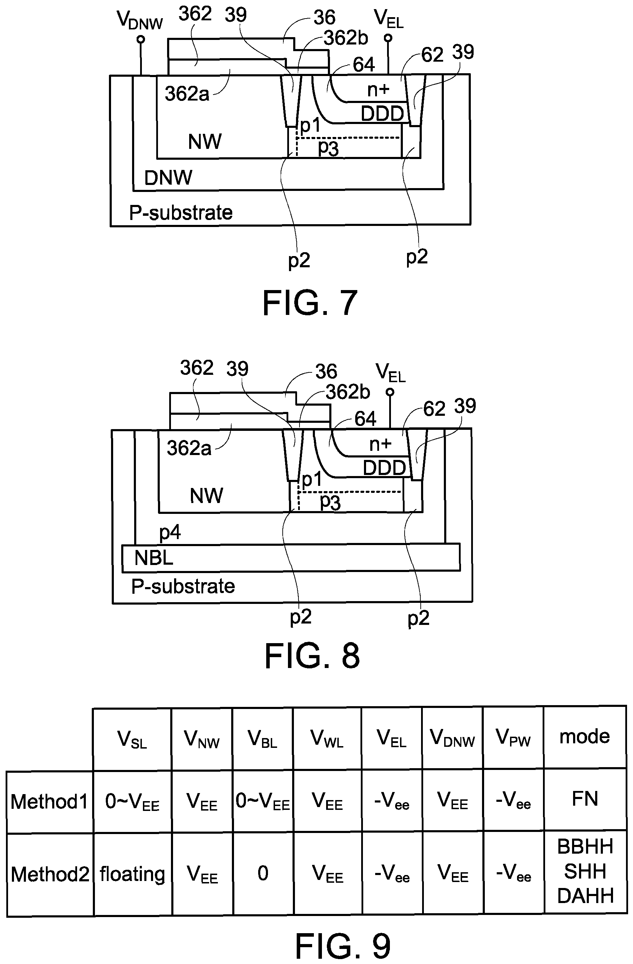

Furthermore, different substrate structures and P-well region (PW) applied to the example shown in FIG. 6A will be illustrated in more details as follows. As shown in FIG. 7, in an embodiment according to the present invention, the substrate structure includes a deep N-well region (DNW), and a P-substrate. The deep N-well region (DNW) is formed in the P-substrate and the deep N-well region (DNW) is connected to a deep N-well voltage V_{DNW}.

The N-well region (NW) and the P-well region (PW) of the embodiment are formed in the substrate structure. Furthermore, the P-well region (PW) further comprises a first p-type region (p1), two second p-type regions (p2), and a third p-type region (p3). The dosage in the second p-type region (p2) is higher than the dosage in the first p-type region (p1). The dosage in the third p-type region (p3) is higher than the dosage in the first p-type region (p1). The dosage in the N-well region (NW) is higher than or equal to the dosage in the first n-type region (n1, i.e. the double diffused drain (DDD) region). Also, the dosage in the first p-type region (p1) is higher than or equal to the dosage in the first n-type region (n1).

In addition, the first p-type region (p1) is formed under the surface of the substrate structure and contacted to the double diffused drain (DDD) region 64; and the third p-type region (p3) is formed under the first p-type region (p1). Furthermore, the first p-type region (p1) and the third p-type region (p3) are located between the two second p-type regions (p2), which are formed under the two isolation structures 39.

According to FIG. 7 of the present invention, the junction breakdown voltage between the first n-type region (n1, i.e. the double diffused drain (DDD) region 64) and the first p-type region (p1) is increased and thus the erase efficiency of the erasable programmable single-poly nonvolatile memory is improved. Furthermore, the second p-type regions (p2) are capable of improving the lateral punch through effect between the double diffused drain (DDD) region 64 and the N-well region (NW) at higher temperature; and the third p-type region (p3) is capable of improving the vertical punch through effect between the double diffused drain (DDD) region 64 and the deep N-well region (DNW) at higher temperature.

As shown in FIG. 8, in an embodiment according to the present invention, the substrate structure includes a fourth p-type region (p4), an n-type barrier layer (NBL, i.e. a second n-type region), and a P-substrate. The n-type barrier layer (NBL) is formed in the substrate structure, and the fourth p-type region (p4) is formed above and contacted to the n-type barrier layer (NBL).

The N-well region (NW) and the P-well region (PW) of the embodiment are formed in the substrate structure. Furthermore, the P-well region (PW) further comprises a first p-type region (p1), two second p-type regions (p2), and a third p-type region (p3). The dosage in the second p-type region (p2) is higher than the dosage in the first p-type region (p1). Also, the dosage in the third p-type region (p3) is higher than the dosage in the first p-type region (p1). In addition, the dosage in the fourth p-type region (p4) is equal to the dosage in the P-substrate. Or, the dosage in the fourth p-type region (p4) is higher than or equal to the dosage in the third p-type region (p3) and the dosage in the fourth p-type region (p4) is lower than or equal to the dosage in the second p-type region (p2).

In addition, the first p-type region (p1) is formed under the surface of the substrate structure and contacted to the double diffused drain (DDD) region 64; and the third p-type region (p3) is formed under the first p-type region (p1). Furthermore, the first p-type region (p1) and the third p-type region (p3) are located between the two second p-type regions (p2), which are formed under the two isolation structures 39.

According to FIG. 8 of the present invention, the junction breakdown voltage between the first n-type region (n1) (i.e. double diffused drain (DDD) region 64) and the first p-type region (p1) is increased and thus the erase efficiency of the erasable programmable single-poly nonvolatile memory is improved. Furthermore, the second p-type region (p2) is capable of improving the lateral punch through effect between the double diffused drain (DDD) region 64 (i.e. the first n type region: n1) and the N-well region (NW) at higher temperature; and the third p-type region (p3) is capable of improving the vertical punch through effect between the double diffused drain (DDD) region 64 and the n-type barrier layer (NBL) at higher temperature. Also, the N-well region (NW) of the embodiment is isolated by the fourth p-type region (p4) and the P-well region (PW), thus the independent bias voltage is capable of reducing the voltage stress between the floating gate 36 and the N-well region (NW).

According to the present invention, some biasing voltages may provide to the embodiments constructed in the deep N-well region (DNW) of the substrate structure as shown in FIGS. 4 and 7 in the erased state. FIG. 9 shows two voltage biasing methods in erased state. As shown in FIG. 9, when the first method is used in the erased state, the source line voltage V_{SL} and the bit line voltage is in a range between 0V to a positive voltage V_{EE}, the N-well voltage V_{NW} and the word line voltage V_{WL} and the deep N-well voltage V_{DNW} is equal to the positive voltage (V_{EE}). Whereas, the erase line voltage V_{EL} and the P-well voltage V_{PW} is equal to a negative voltage -Vₑₑ. The positive voltage V_{EE} is in the range between +6.5V and +18V and the negative voltage -Vₑₑ is in the range between -6.5V and -18V. In this way, the ejection of the storage carriers can be achieved by using Fowler-Nordheim (FN) effect

As shown in FIG. 9, when the second method is used in the erased state, the source line voltage V_{SL} is floating, and the bit line voltage is in a ground voltage (0V), and the N-well voltage V_{NW} and the word line voltage V_{WL} and the deep N-well voltage V_{DNW} is equal to the positive voltage (V_{EE}). Whereas, the erase line voltage V_{EL} and the P-well voltage V_{PW} is equal to a negative voltage -Vₑₑ. The positive voltage V_{EE} is in the range between +6.5V and +18V and the negative voltage -Vₑₑ is in the range between -6.5V and -18V. In this way, the ejection of the storage carriers can be achieved by using Hot Hole (HH) effect, such as, band-to-band hot hole (BBHH) effect, substrate hot hole (SHH) effect, and drain avalanche hot hole (DAHH) effect

From the above description, the erasable programmable single-poly nonvolatile memory of the present invention is capable of decreasing the erase line voltage (V_{EL}). That is, by providing a lower erase line voltage V_{EL}, storage state of the nonvolatile memory of the present invention is changeable.

## Claims

1. An erasable programmable single-poly nonvolatile memory, comprising:
a substrate structure, an N-well region (NW), a P-well region (PW, p1, p2, p3) and isolation structures (39) formed in said substrate structure, wherein one isolation structure (39) is formed between said N-well region (NW) and said P-well region (PW);
a floating gate transistor comprising a floating gate (36), a gate oxide layer (362) under the floating gate (36), and a channel region, wherein the channel region is formed in said N-well region (NW); and
an erase gate region (38, p1, p2, p3, 62, 64) wherein the floating gate (36) extends over the erase gate region (38, p1, p2, p3, 62, 64) and the erase gate region comprises said P-well region (PW, p1, p2, p3) and a first n-type region (38, 62, 64) connected to an erase line voltage (V_{EL});
**characterized in that** the gate oxide layer (362) comprises a first portion (362a) above the channel region of the floating gate transistor and a second portion (362b) above the erase gate region, and a thickness of the first portion (362a) of the gate oxide layer (362) is thicker than a thickness of the second portion (362b) of the gate oxide layer (362);
the P-well region (PW) comprises: a first p-type region (p1) formed under a surface of the substrate structure and contacted to the first n-type region (38, 62, 64); two second p-type regions (p2); and a third p-type region (p3) formed under the first p-type region (p1); and the first p-type region (p1) and the third p-type region (p3) are located between the second p-type regions (p2), said two second p-type regions (p2) being located under said one isolation structure (39) and under another isolation structure (39), respectively; and
a dosage in the second p-type regions (p2) is higher than a dosage in the first p-type region (p1), and a dosage in the third p-type region (p3) is higher than the dosage in the first p-type region (p1).

2. The erasable programmable single-poly nonvolatile memory as claimed in claim 1, wherein the first n-type region (62, 64) further comprises a n-type source/drain region (62) connected to the erase line voltage (V_{EL}) and a double diffused drain region (64) formed between the n-type source/drain region (62) and the P-well region (PW).

3. The erasable programmable single-poly nonvolatile memory as claimed in claim 2, wherein a dosage in the first p-type region (p1) is higher than or equal to a dosage in the double diffused drain region (64).

4. The erasable programmable single-poly nonvolatile memory as claimed in claim 1, wherein the substrate structure comprises:
a P-substrate; and
a deep N-well region (DNW) formed in the P-substrate, wherein the deep N-well region (DNW) is contacted to the N-well region (NW), the second p-type regions (p2) and the third p-type region (p3) and the deep N-well region (DNW) is connected to a deep N-well voltage (V_{DNW}).

5. The erasable programmable single-poly nonvolatile memory as claimed in claim 1, wherein the substrate structure comprises:
a P-substrate;
a second n-type region (NBL) formed in the P-substrate; and
a fourth p-type region (p4) formed above and contacted to the second n-type region (NBL), wherein the fourth p-type region (p4) is contacted to the N-well region (NW), the second p-type regions (p2) and the third p-type region (p3).

6. The erasable programmable single-poly nonvolatile memory as claimed in claim 5, wherein a dosage in the fourth p-type region (p4) is higher than or equal to a dosage in the P-substrate, the dosage in the fourth p-type region (p4) is higher than or equal to the dosage in the third p-type region (p3), and the dosage in the fourth p-type region (p4) is lower than or equal to the dosage in the second p-type region (p2).

## Patentansprüche

1. Löschbarer programmierbarer nichtflüchtiger Einzel-Mehr-Speicher, der aufweist:
eine Substratstruktur, einen Bereich (NW) einer N-Wanne, einen Bereich (PW, p1, p2, p3) einer P-Wanne und Isolationsstrukturen (39), die in der Substratstruktur ausgebildet worden sind, wobei eine Isolationsstruktur (39) zwischen dem Bereich (NW) der N-Wanne und dem Bereich (PW) der P-Wanne ausgebildet worden ist,
einen Schwebender-Gatter-Transistor, der ein schwebendes Gatter (36), eine Gatteroxidschicht (362) unter dem schwebenden Gatter (36) und einen Kanalbereich aufweist, wobei der Kanalbereich in dem Bereich (NW) der N-Wanne ausgebildet worden ist, und
einen Löschgatter-Bereich (38, p1, p2, p3, 62, 64), wobei sich das schwebende Gatter (36) über den Löschgatter-Bereich (38, p1, p2, p3, 62, 64) erstreckt und wobei der Löschgatter-Bereich (35) den Bereich (PW, p1, p2, p3) der P-Wanne und einen Bereich (38, 62, 64) vom ersten n-Typ aufweist, der mit einer Löschleitungsspannung (VEL) verbunden ist,
**dadurch gekennzeichnet, dass** die Gatteroxidschicht (362) einen ersten Abschnitt (362a) über dem Kanalbereich des schwebenden Gatters und einen zweiten Abschnitt (362b) über dem Löschgatter-Bereich aufweist und dass eine Dicke des ersten Abschnitts (362a) der Gatteroxidschicht (362) dicker als eine Dicke des zweiten Abschnitts (362b) der Gatteroxidschicht (362) ist,
dass der Bereich (PW) der P-Wanne einen Bereich (p1) vom ersten p-Typ, der unter einer Oberfläche der Substratstruktur ausgebildet worden ist und mit dem Bereich (38, 62, 64) vom ersten n-Typ kontaktiert ist, zwei Bereiche (p2) vom zweiten p-Typ, und einen Bereich (p3) vom dritten p-Typ aufweist, der unter dem Bereich (p1) vom ersten p-Typ ausgebildet worden ist, und dass der Bereich (p1) vom ersten p-Typ und der Bereich (p3) vom dritten p-Typ sich zwischen den Bereichen (p2) vom zweiten p-Typ befinden, wobei sich die zwei Bereiche (p2) vom zweiten p-Typ unter der einen Isolationsstruktur (39) bzw. unter der anderen Isolationsstruktur (39) befinden, und
dass eine Dotierung in den Bereichen (p2) vom zweiten p-Typ höher als eine Dotierung in dem Bereich (p1) vom ersten p-Typ ist und eine Dotierung in den Bereich (p3) vom dritten p-Typ höher als die Dotierung in dem Bereich (p1) vom ersten p-Typ ist.

2. Löschbarer programmierbarer nichtflüchtiger Einzel-Mehr-Speicher nach Anspruch 1, wobei der Bereich (62, 64) vom ersten n-Typ ferner einen Quellen- / Senkenbereich (62) vom n-Typ, der mit der Löschleitungsspannung (VEL) verbunden ist, und einen doppelt diffundierten Senkenbereich (64) aufweist, der zwischen dem Quellen- / Senkenbereich (62) vom n-Typ und dem Bereich (PW) der P-Wanne ausgebildet worden ist.

3. Löschbarer programmierbarer nichtflüchtiger Einzel-Mehr-Speicher nach Anspruch 2, wobei eine Dotierung in dem Bereich (p1) vom ersten p-Typ höher eine als oder gleich einer Dotierung in dem doppelt diffundierten Senkenbereich (64) ist.

4. Löschbarer programmierbarer nichtflüchtiger Einzel-Mehr-Speicher nach Anspruch 1, wobei die Substratstruktur aufweist:
ein P-Substrat, und
einen Bereich (DNW) einer tiefen N-Wanne, der in dem P-Substrat ausgebildet worden ist, wobei der Bereich (DNW) einer tiefen N-Wanne mit dem Bereich (NW) der N-Wanne, den Bereichen (p2) vom zweiten p-Typ und dem Bereich (p3) vom dritten p-Typ kontaktiert ist und wobei Bereich (DNW) der tiefen N-Wanne mit einer tiefen N-Wannen-Spannung (V_{DNW}) verbunden ist.

5. Löschbarer programmierbarer nichtflüchtiger Einzel-Mehr-Speicher nach Anspruch 1, wobei die Substratstruktur aufweist:
ein P-Substrat,
einen zweiten Bereich (NBL) vom n-Typ, der in dem P-Substrat ausgebildet ist, und
einen Bereich (p4) vom vierten p-Typ, der darüber ausgebildet worden und mit dem Bereich (NBL) vom zweiten n-Typ kontaktiert ist, wobei der Bereich (p4) vom vierten p-Typ mit dem Bereich (NW) der N-Wanne, den Bereichen (p2) vom zweiten p-Typ und dem Bereich (p3) vom dritten p-Typ kontaktiert ist.

6. Löschbarer programmierbarer nichtflüchtiger Einzel-Mehr-Speicher nach Anspruch 5, wobei eine Dotierung in dem Bereich (p4) vom vierten p-Typ höher als eine oder gleich einer Dotierung in dem P-Substrat ist, wobei die Dotierung in dem Bereich (p4) vom vierten p-Typ höher als die oder gleich der Dotierung in dem Bereich (p3) vom dritten p-Typ ist und die Dotierung in dem Bereich (p4) vom vierten p-Typ niedriger als die oder gleich der Dotierung in dem Bereich (p2) vom zweiten p-Typ ist.

## Revendications

1. Mémoire non volatile de type single-poly effaçable et programmable, comprenant :
une structure de substrat, une région de puits N (NW), une région de puits P (PW, p1, p2, p3) et des structures d'isolation (39) formées dans ladite structure de substrat, dans laquelle une structure d'isolation (39) est formée entre ladite région de puits N (NW) et ladite région de puits P (PW) ;
un transistor à grille flottante comprenant une grille flottante (36), une couche d'oxyde de grille (362) en dessous de la grille flottante (36), et une région de canal, dans laquelle la région de canal est formée dans ladite région de puits N (NW) ; et
une région de grille d'effacement (38, p1, p2, p3, 62, 64), dans laquelle la grille flottante (36) s'étend sur la région de grille d'effacement (38, p1, p2, p3, 62, 64) et la région de grille d'effacement comprend ladite région de puits P (PW, p1, p2, p3) et une première région de type n (38, 62, 64) connectée à une tension de ligne d'effacement (V_{EL}) ;
**caractérisée en ce que** la couche d'oxyde de grille (362) comprend une première portion (362a) au-dessus de la région de canal du transistor à grille flottante et une seconde portion (362b) au-dessus de la région de grille d'effacement, et une épaisseur de la première portion (362a) de la couche d'oxyde de grille (362) est plus importante qu'une épaisseur de la seconde portion (362b) de la couche d'oxyde de grille (362) ;
la région de puits P (PW) comprend: une première région de type p (p1) formée en dessous d'une surface de la structure de substrat et mise en contact avec la première région de type n (38, 62, 64) ;
deux deuxièmes régions de type p (p2) ; et une troisième région de type p (p3) formée en dessous de la première région de type p (p1) ; et la première région de type p (p1) et la troisième région de type p (p3) sont situées entre les deuxièmes régions de type p (p2), lesdites deux deuxièmes régions de type p (p2) étant situées en dessous de ladite structure d'isolation (39) et en dessous d'une autre structure d'isolation (39), respectivement ; et
un dosage dans les deuxièmes régions de type p (p2) est supérieur à un dosage dans la première région de type p (p1), et un dosage dans la troisième région de type p (p3) est supérieur au dosage dans la première région de type p (p1).

2. Mémoire non volatile de type single-poly effaçable et programmable selon la revendication 1, dans laquelle la première région de type n (62, 64) comprend en outre une région de source/drain de type n (62) connectée à la tension de ligne d'effacement (V_{EL}) et une région de drain de double diffusion (64) formée entre la région de source/drain de type n (62) et la région de puits P (PW).

3. Mémoire non volatile de type single-poly effaçable et programmable selon la revendication 2, dans laquelle un dosage dans la première région de type p (p1) est supérieur ou égal à un dosage dans la région de drain de double diffusion (64).

4. Mémoire non volatile de type single-poly effaçable et programmable selon la revendication 1, dans laquelle la structure de substrat comprend :
un substrat P ; et
une région de puits N profond (DNW) formée dans le substrat P, dans laquelle la région de puits N profond (DNW) est mise en contact avec la région de puits N (NW), les deuxièmes régions de type p (p2) et la troisième région de type p (p3) et la région de puits N profond (DNW) est connectée à une tension de puits N profond (V_{DNW}).

5. Mémoire non volatile de type single-poly effaçable et programmable selon la revendication 1, dans laquelle la structure de substrat comprend :
un substrat P ;
une seconde région de type n (NBL) formée dans le substrat P ; et
une quatrième région de type p (p4) formée au-dessus et mise en contact avec la seconde région de type n (NBL), dans laquelle la quatrième région de type p (p4) est mise en contact avec la région de puits N (NW), les deuxièmes régions de type p (p2) et la troisième région de type p (p3).

6. Mémoire non volatile de type single-poly effaçable et programmable selon la revendication 5, dans laquelle un dosage dans la quatrième région de type p (p4) est supérieur ou égal à un dosage dans le substrat P, le dosage dans la quatrième région de type p (p4) est supérieur ou égal au dosage dans la troisième région de type p (p3), et le dosage dans la quatrième région de type p (p4) est inférieur ou égal au dosage dans la deuxième région de type p (p2).
